(19) Europäisches Patentamt / European Patent Office / Office européen des brevets

(11) **EP 4 624 883 A1**

(12) **EUROPEAN PATENT APPLICATION**

(43) Date of publication:
 **01.10.2025 Bulletin 2025/40**

(21) Application number: **24165992.9**

(22) Date of filing: **25.03.2024**

(51) International Patent Classification (IPC):
 **G01K 1/20** *(2006.01)*      **G01K 7/42** *(2006.01)*
 **H02H 6/00** *(2006.01)*

(52) Cooperative Patent Classification (CPC):
 **G01K 7/42; G01K 1/20; H02H 6/00**

(84) Designated Contracting States:
 **AL AT BE BG CH CY CZ DE DK EE ES FI FR GB
 GR HR HU IE IS IT LI LT LU LV MC ME MK MT NL
 NO PL PT RO RS SE SI SK SM TR**
 Designated Extension States:
 **BA**
 Designated Validation States:
 **GE KH MA MD TN**

(71) Applicant: **ABB SCHWEIZ AG
 5400 Baden (CH)**

(72) Inventors:
 • **GAREGNANI, Giacomo**
  **8003 Zürich (CH)**
 • **SCHLOTTIG, Gerd**
  **8142 Uitikon Waldegg (CH)**
 • **HENCKEN, Kai**
  **79539 Lörrach (DE)**

(74) Representative: **Maiwald GmbH
 Engineering
 Elisenhof
 Elisenstrasse 3
 80335 München (DE)**

(54) **METHOD FOR AN ELECTRICAL SYSTEM**

(57)    The disclosure relates to a method (100) for an electrical system (10), the method comprising:
- obtaining measurement data indicative of a measured temperature profile at a position of an electrical part (11) of the electrical system (10), wherein the measured temperature profile is based at least on:
a first temperature of the electrical part (11) over time relating to a self-heating due to resistive loss of the electrical part (11), and
at least a second temperature over time relating to a heating due to resistive loss of a surrounding portion (16) of the electrical system (10), the surrounding portion (16) at least partially surrounding the electrical part (11);

- obtaining characteristic data of the electrical part (11), the characteristic data comprising at least one characteristic temperature profile of a temperature of the electrical part (11) over time due to the self-heating of the electrical part (11) or of a temperature of the electrical part (11) over time due to the heating of the surrounding portion (16); and
- determining the first temperature of the electrical part (11) overtime based on the measurement data and the characteristic data.

Fig. 1

**Description**

**TECHNICAL FIELD**

The present invention relates to a method for an electrical system, a data processing system, an electrical system comprising the electrical part, a computer program, and a computer-readable storage medium.

**BACKGROUND OF THE INVENTION**

Thermal problems are common in electrical systems, such as electrical resistance of electrical parts increases over its lifetime, but not only. For example, due to aging processes like loosening and degradation of electric contacts or the degradation of insulating material or similar leading to overheating. Detecting such thermal issues associated with a possible fault is difficult due to the variable current and therefore variable heating power in such systems. In addition, the thermal response is often quite slow.

In common electrical systems, various sensors are used to predict thermal issues of electrical parts of an electrical system. Simple approaches that exploit fixed temperature thresholds are of limited or no benefit. The variability of the temperature due to different heating source terms limits the applicability of these simple approaches based on fixed temperature thresholds. However, due to variable heating conditions of an electrical system during operation an excessive overtemperature may be reached and it might be too late to maintenance or replace the electrical part.

Summarizing, models based on thresholds may allow to detect a failure but do not allow to identify faults or fault conditions and to track degradation or aging of an electrical part within an electrical system, in particular not based on an increased contact resistance or dielectric losses of the electrical part due to its operation over its lifetime.

**SUMMARY OF THE INVENTION**

The above problem or need is at least partially solved or alleviated by the subject matters of the independent claims of the present disclosure, wherein further examples are incorporated in the dependent claims.

According to a first aspect, there is provided a method for an electrical system, the method comprising:

- obtaining measurement data indicative of a measured temperature profile at a position of an electrical part of the electrical system, wherein the measured temperature profile is based at least on:

  ○ a first temperature of the electrical part over time relating to a self-heating due to resistive loss of the electrical part, and
  ○ at least a second temperature over time relating to a heating due to resistive loss of a surrounding portion of the electrical system, the surrounding portion at least partially surrounding the electrical part;

- obtaining characteristic data of the electrical part, the characteristic data comprising at least one characteristic temperature profile of a temperature of the electrical part over time due to the self-heating of the electrical part or a temperature of the electrical part over time due to the heating of the surrounding portion; and
- determining the first temperature of the electrical part over time based on the measurement data and the characteristic data.

The method of the first aspect may in particular be an at least partially or fully computer implemented method. This means that at least one, multiple or all of the steps of the method may be carried out by a data processing system, which may comprise one or more computers or computing units, which may be part of the electrical system or not, e.g., integrated therewith or connected thereto. Different steps may be carried out by the same or by different computers. A computer is herein understood as a data processing apparatus or device, which can carry out some, multiple or all steps as defined by the method. Specifically, the obtaining of the measurement data, characteristic data and/or determining of a state of health may be carried out by the data processing system. Additionally, or alternatively, the obtaining of the measurement data may be carried out by a measurement device or system, which may optionally forward the measurement data to the data processing system such that it may obtain the measurement data.

The method of the first aspect of this disclosure allows for accurate determination of a self-heating of an electrical part or dielectric losses due to resistive loss, which is based on measurement data indicative of a measured temperature profile at a position of an electrical part of the electrical system.

The first temperature over time refers to the temperature increase of the electrical part itself over time and is thus called self-heating. This self-heating may be generated due to an internal resistive loss of the electrical part during operation for example. For instance, when an electric current flows through the electrical part, heat is generated due to the electrical resistance of the material comprising electrical part. This heating effect is due to Joule's law ($P = I^2R$) and is also called resistive loss. The first temperature may further refer to an overtemperature for example. The second temperature over time refers to the temperature of the surrounding portion of the electrical system, which also experiences heating due to resistive losses. This surrounding portion may include various components or materials that are in proximity to the electrical part being measured like other electrical parts, adjacent components, or other components of the electrical system affected due to resistive loss.

The method of the first aspect is further based on characteristic data of the electrical part, which comprise at least one characteristic temperature profile. This temperature profile may indicate the temperature increase of the electrical part over time due to its self-heating or heating by the surrounding portion. This characteristic data may reflect how the temperature profile of the electrical part increases over time as it self-heats, primarily due to its own resistive losses during operation of the electrical system. This profile may be predetermined through experiments or simulations. Specifically it may be beneficial collecting this characteristic data of the electrical part under various operating conditions to generate characteristic data for each of the operating conditions of the electrical system. For example, characteristic temperature profiles may be measured or simulated under different load conditions or ambient temperatures. The characteristic temperature profile of the electrical part due to heating from the surrounding portion of the electrical part may describe how the temperature of the electrical part increases over time as it is heated by the surrounding portion. This heating can occur due to resistive losses in the surrounding components or an ambient temperature for example. Similar to the temperature profile due to self-heating, these profiles may be determined through previous experiments or simulations that investigate the heat transfer behavior between the electrical part and its surroundings.

The method of the first aspect further involves determining the first temperature of the electrical part over time based on the measurement data and the characteristic data. The measurement data, which may be obtained from the temperature measurement device, may provide the measured temperature profile of the electrical part or parts of the electrical part. This measurement data may capture actual temperature changes experienced by the electrical part during operation. The characteristic data may comprise temperature profiles predetermined by experiments or simulations for example. These temperature profiles may represent an expected temperature development of the electrical part, including self-heating or heating from the surrounding portion, under various conditions. By comparing the measured temperature profile with the characteristic temperature profile, the contribution of the self-heating of the electrical part to an overall temperature increase of the electrical part may be determined. It may be sufficient to use only one characteristic temperature profile for determining the self-heating. By using a single characteristic temperature, the complexity of the analysis may be reduced, and the determining of the self-heating may be simplified. This determination of the self-heating of the electrical part may be crucial for understanding the thermal behavior of the electrical part, for example to be able to make predictions about the degradation status or state of health or similar. For instance, making informed decisions regarding maintenance, performance optimization, or potential issues detection or to determine a health status of the electrical part respectively.

For determination of the self-heating only a single temperature measurement device like a temperature sensor may be required. By placing the temperature sensor at an appropriate position within the electrical system, for example onto or adjacent to the electrical part, the temperature changes due to the self-heating of the electrical part and the surrounding portions may be determined. The temperature sensor may for example continuously measure the temperature at this location over a defined period of time. The characteristic data, comprising a temperature profile of the electrical part over time due to self-heating or heating of the surrounding portion, may be predetermined through experimental or simulation methods. This characteristic data serve as reference profile against which the measured temperature data are compared. The measurement data may then be compared to the predetermined characteristic temperature profile, comprising the at least one characteristic temperature profile of a temperature of the electrical part over time due to the self-heating of the electrical part or a temperature of the electrical part over time due to the heating of the surrounding portion, to determine the self-heating of the electrical part.

In an example, the first temperature of the electrical part over time may be determined based on a fitting of the measurement data with the characteristic data. For example, one or more equations may be used as further specified herein below in the detailed description of the invention. A methodical approach may be used to determine most suitable parameters that minimize a disparity between the measurement data and the characteristic data of the electrical part. For example, a mathematical model may be selected to provide the characteristic temperature increase of the electrical component over time. This model may comprise exponential functions due to their suitability in capturing dynamic thermal behaviors. Subsequently, parameter estimation techniques may be utilized to determine parameters within the chosen model that best align the model with the measured temperature data. These parameters may represent intrinsic characteristics of the system, such as time constants or amplitudes. An objective function may then be defined to quantify the deviation between the actual temperature measurements and the model predictions. This objective function may measure residuals, such as the sum of squared differences between measured and predicted temperatures at each time point. In a next step, optimization algorithms may for example be employed to adjust the parameters of this model, minimizing the difference between the measurement data and characteristic data. This process may allow to precisely model the characteristic temperature increase within the component, effectively distinguishing the "self-heating" from other influences as heating of the surrounding portion of the electrical system. In summary, the first temperature, representing the self-heating of the electrical part, may be determined through fitting by aligning the measured temperature data with the characteristic temperature profiles of the electrical part. By adjusting the parameters of a mathematical model to minimize the difference between the measured and predicted temperature data, optimization algorithms may facilitate the precise modeling of temperature variations within the component. This process may enable for accurate quantification of the self-heating of the electrical part. This may be beneficial when determining the health status of the electrical component.

In an example, the at least one characteristic temperature profile may comprise a first characteristic temperature profile of a temperature of the electrical part over time due to the self-heating of the electrical part. This first characteristic temperature profile may indicate how the temperature of the electrical part evolves because of its internal resistive losses or heat generation mechanisms. The at least one characteristic temperature profile may further comprise a second characteristic temperature profile of a temperature of the electrical part over time due to the heating of the surrounding portion. This second characteristic temperature profile may indicate how the temperature of the electrical part responds to the heat generated within its surrounding portion, such as adjacent components or electrical parts or the electrical system itself for example respectively. The second characteristic temperature profile may be representative for thermal interactions between the electrical part and its surrounding portion, highlighting the influence of external factors on the temperature increase of the electrical part. The first characteristic temperature profile and the second characteristic temperature profile may be temperature profiles predetermined by experiments or simulations for example. By introducing the first characteristic temperature profile and the second characteristic temperature profile, the method may be more precise in differentiating between the various heat sources, enabling a more accurate assessment of the health state of the electrical part for example.

In an example, the first characteristic temperature profile of a temperature of the electrical part and the second characteristic temperature profile of a temperature of the electrical part may be obtained under a fault-free operation of the electrical system and the method may further comprise determining a state of health of the electrical part based on the first temperature of the electrical part over time and a threshold temperature of the electrical part over time indicative of a fault operation of the electrical part. These characteristic profiles may be determined based on simulations or experimental measurements conducted under fault-free operating conditions. With both the measurement data and characteristic data, the state of health of the electrical part may be determined. This may be achieved by analyzing the first temperature profile of the electrical part over time and comparing it to a threshold temperature of the electrical part indicative of fault operation. The threshold temperature of the electrical part may serve as a reference, indicating temperature levels at which the electrical part is considered to be operating abnormally, potentially indicating a fault condition, for example. By comparing the first temperature profile with the threshold temperature of the electrical part, the method may identify deviations from expected temperature behavior of the electrical part. If the temperature profile of the electrical part exceeds the threshold levels over time, it may suggest that the electrical part may be experiencing abnormal conditions indicative of a fault. This information allows for example for timely intervention or maintenance to prevent further degradation or failure of the electrical system.

Further, by utilizing physical measurement data as the temperature increase over time of the electrical part from the actual operation of the system, a more accurate and reliable assessment of the state of health of the electrical part may be achieved. Through the direct capture of temperature data from the electrical system's operation, this method can accurately detect deviations or anomalies in the temperature behavior of the electrical part. These deviations may indicate potential issues or degradation affecting the state of health of the electrical part. In contrast, purely model-based methods for example may struggle to accurately model all relevant influencing factors and dynamics of the system, leading to less precise condition assessments. Thus, by using physical measurement data instead of purely modeled data, this method offers improved reliability and accuracy in determining the condition of the electrical component. This enables more effective decision-making regarding maintenance, repair, or replacement of the component, ultimately enhancing the reliability and performance of the entire electrical system.

In an example, a thermal mass of the electrical part may be smaller than a thermal mass of the surrounding portion. In this context, if a thermal mass of the electrical part is smaller than a thermal mass of the surrounding portion, this may imply that the electrical part responds more quickly to changes due to changes in the load or heating losses compared to the surrounding portion for example. This characteristic may for example influence the rate at which the temperature increases in response to changes in operating conditions. In an exponential function which may be used to model the temperature increase over time for example, the time constant ($\tau$) represents a characteristic time scale of the system's response to changes in temperature. A smaller thermal mass thus may result in a smaller time constant, indicating a faster response to changes in the load or heating losses for example. In practical terms, this may mean that the temperature of the electrical part will rise or fall more rapidly compared to the surrounding portion when subjected to heating for example. This difference in response rates can be leveraged to distinguish between the temperature contributions from the electrical part's self-heating and the heating of the surrounding portion. By analyzing the rate of temperature change with the exponential function, these contributions may be effectively separated and the state of health of the electrical part may be determined.

In an example, the characteristic data may be predetermined based on at least one simulation of the electrical system, and/or at least one usage condition with the electrical system. This may mean that the characteristic temperature profiles of the electrical part can be determined based on both simulations, like computer simulations, and/or actual operating conditions of the electrical system. For instance, computer simulations can be used to predict the thermal behavior of the electrical system under various operating conditions. These simulations may take into account parameters such as load changes, ambient temperature, and ventilation conditions for example to generate the characteristic temperature profiles. Moreover, the characteristic data may also be determined from operational data of the electrical system. This could involve obtaining and analyzing temperature profiles during a normal operation of the system over a certain period or similar for example. These data could then be used to identify and quantify a characteristic temperature profile of the electrical part under different operating conditions.

In an example, the measurement data indicative of a measured temperature profile may be obtained during a period of a temperature increase over time. This may mean that the measurement of the temperature on or at the electrical part may be conducted while the electrical system is experiencing a temperature increase for example. The period of temperature increase may comprise clear and discernible trends in temperature data. These trends in temperature may include distinct thermal characteristics like exponential temperature rises, plateau phases, or other identifiable patterns that reflect the system's response to changing conditions, making it easier to analyze and interpret the temperature data.

In an example, the temperature increase over time may be during a substantially exponential temperature increase. A substantially exponential temperature increase may refer to a situation where the temperature increase follows a pattern that closely resembles an exponential function. A substantially exponential temperature increase may refer to a situation where the temperature increase follows a pattern closely resembling an exponential function. An exponential temperature increase may imply that the temperature rises at an increasingly rapid rate over time. This may involve the temperature doubling at regular intervals or growing exponentially in a similar manner. An exponential temperature increase may for example mean that the temperature initially increases slowly but then accelerates over time, resulting in a very steep temperature rise at the end of the period. The exponential function describes this behaviour well, although the actual temperature increase may not perfectly match the mathematical curve. In practice, this could mean that the temperature begins to increase exponentially due to factors such as self-heating or other thermal effects, before slowing down over time and finally an asymptotic value or a plateau for example. The temperature increase may not perfectly adhere to an exponential curve, but may closely approximate one.

In an example, the period of the temperature increase over time may be during a start-up phase of the electrical system or between steady-state temperatures of the electrical part. A start-up phase may refer to an initial period when the electrical system is powered on or activated, transitioning from a state of rest to full operation. The start-up phase may be characterized by rapid temperature changes as the system reaches its operational state. For example, electrical parts may experience an increase in temperature as current flows through them, causing resistive loss. The exponential temperature increase during the startup phase may provide good comparability and reproducibility of temperature conditions because similar dynamic processes typically occur during this phase. This may for example allow for a consistent evaluation of temperature changes and facilitates comparison between different measurements or tests. Additionally, the exponential temperature increase may enable a more precise characterization of the thermal properties of the electrical components like the electrical part and the surrounding portion of the electrical system, as it may provide a clear relationship between the applied load and the resulting temperature change. A steady-state temperature may refer to conditions where the system has reached a stable operating state with consistent temperature levels for example. During a steady-state operation, the electrical part and the electrical system may have stabilized, and the thermal equilibrium may be maintained over time.

In an example, the electrical part may be an electrical contact, an electrical portion or an electrical component of the electrical system. Further, the electrical system may be formed by the electrical part or component (i.e., have only the electrical part, such that the electrical system as such is being checked for a state of health) or may have multiple electrical parts or components. The electrical system may in particular be an electrical device. The electrical portion may be a portion of an electrical component, for example, and not necessarily the entire electrical component. Further, the electrical part may be a capacitor or a part of a capacitor, such as a metalized film used in certain types of capacitors.

For example, the measured temperature profile may be based on a temperature measured by a temperature sensor of the electrical system, in particular the electrical part. The method involves obtaining measurement data indicative of a measured temperature profile at a position of an electrical part of the electrical system. This measured temperature profile may be based on temperature measurements obtained by a single temperature sensor located within the electrical system. This temperature sensor may be part of the electrical part itself or integrated into different components of the electrical system. The sensor can be strategically positioned at a location within the electrical system to capture temperature variations of the electrical part accurately.

According to a second aspect of this disclosure, there is provided a data processing system configured to carry out the method according to the first aspect of this disclosure.

The data processing system may comprise one or more computers as previously described and, optionally, the computer program product of the second aspect of this disclosure.

According to a third aspect of this disclosure, there is provided an electrical system comprising an electrical part, a measurement arrangement configured to measure a temperature profile of a temperature of the electrical part, and the data processing system according to the second aspect of this disclosure.

According to a fourth aspect of this disclosure, there is provided a computer program product comprising instructions which, when the program is executed by a computer, cause the computer to carry out the method according to the first aspect of this disclosure.

The computer program product may be a computer program as such, meaning a computer program consisting of or comprising a program code to be executed by the computer.

Alternatively, the computer program product may be a product such as a data storage, in particular a computer-readable data storage medium, on which the computer program may be temporarily or permanently stored.

For example, the electrical system may also comprise several electrical parts. The measurement arrangement may comprise one or more temperature sensors for example.

According to a fifth aspect of this disclosure, there is provided a computer-readable storage medium comprising instructions which, when executed by a computer, cause the computer to carry out the method of any one of claims 1 to 11.

It is noted that the above aspects, examples and features may be combined with each other irrespective of the aspect involved.

The above and other aspects of the present disclosure will become apparent from and elucidated with reference to the examples described hereinafter.

## BRIEF DESCRIPTION OF THE DRAWINGS

Exemplary embodiments will be further described with reference to Figures, wherein:

Figure 1 shows an electrical system;
Figure 2 shows a graph with different temperature profiles; and
Figure 3 shows a method for determining a health status of an electrical part of the electrical system of Fig. 1.

The Figures are schematic only and not true to scale. In principle, identical or like parts, elements and/or steps are provided with identical or like reference numerals in the Figures.

## DETAILED DESCRIPTION OF THE INVENTION

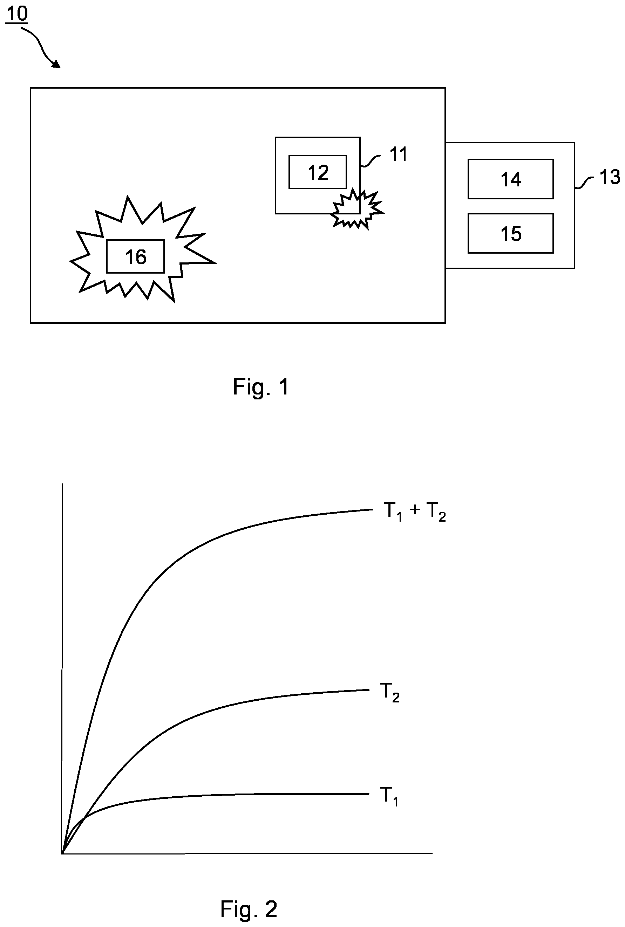

Figure 1 schematically shows an electrical system 10 exemplary comprising an electrical part 11. As an example, one electrical part 11 is shown, however, the number may be higher, e.g. two or three electrical parts 11, or larger. The electrical system 10 may be a power conversion system, such as but not limited to an Alternating Current (AC) system, a busbar system or an electrical filter system. The electrical part 11 may be any electrical part such as but not limited to electrical contacts, electrical portions and/or electrical components of the electrical system 10, e.g., a capacitor or part of a capacitor.

A data processing system 13 may be part of the electrical system 10 or connected thereto, e.g., via a wire or wirelessly, in particular to one or more temperature measurement devices 12 or sensors, exemplary shown with one for the electrical part 11 and exemplary positioned at the electrical part 11. Alternatively the measurement device 12 may be located at a different position within the electrical system 10 or outside thereof but configured for measuring the temperature of the electrical part 11. Moreover, the measurement device 12 may be combinatory measurement devices 12 for both, the temperature and the electrical current measurement, in particular over time, or separate devices 12.

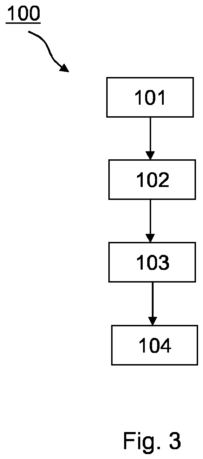

The data processing system 13 may comprise a data processing device 14, in particular in the form of a processing or computing unit or a processor and a computer, and/or a computer program product 15, e.g., in the form of a computer program as such or in the form of a computer-readable storage medium, having stored there on the computer program. When the computer program product 15 is executed by the data processing device 14, the method 100 shown in Fig. 3 is executed.

The background of the method 100 is that it is typical to monitor the thermal behaviour of electrical systems 10 such as the one shown in Fig. 1, since overheating thereof and/or of one or more of its electrical parts 11 is one of the major causes for their failures. A difficulty for thermal monitoring is given by the variability in thermal loads of different components of an electrical system 10 due to different size and thus thermal mass of the different components for example. A temperature increase of the electrical part 11 may for example be due to a self-heating or resistive loss of the electrical part 11 and/or due to a heating or resistive loss of a surrounding portion 16 of the electrical system, wherein the surrounding portion 16 is at least partially surrounding the electrical part 11. A thermal mass of the electrical part 11 in this example is smaller than the thermal mass of the surrounding portion 16 (indicated by the explosives of different size). This may imply that the electrical part 11 responds more quickly to changes in temperature compared to the surrounding portion 16. In the context of the example provided, if the thermal mass of the electrical part 11 is smaller than that of the surrounding portion 16, it may mean that the electrical part 11 heats up or cools down more rapidly compared to the surrounding portion 16 when subjected to the same thermal stimuli for example. This characteristic may influence the rate at which the temperature increases or decreases in response to changes in operating conditions. For instance, during temperature changes at operational conditions within the electrical system 10, the electrical part 11 may exhibit more rapid temperature variations compared to the surrounding portion 16. This can affect the response time of the electrical part 11 to changes in operating conditions and can influence its thermal behaviour. Therefore, the smaller thermal mass of the electrical part 11 relative to the surrounding portion 16 may indicate that the electrical part 11 may respond more quickly to temperature changes, which is an important factor to consider when analyzing its thermal characteristics and behaviour within the electrical system 10. To determine a health status of the electrical part 11 for example it is crucial to distinguish both, the self-heating and the heating of the surrounding portion 16 contributions to the temperature increase of the electrical part 11.

Figure 2 schematically illustrates different temperature profiles.

In this example, a measured temperature increase over time, or measured temperature profile, $T_1 + T_2$ is shown. The measured temperature profile in this example is based on two temperature components, namely $T_1$ and $T_2$. The measured temperature profile may be provided by a measurement device 12. This measured temperature profile may be fitted to a single exponential form or function and could be formulated as follows:

$$T(t) = T_\infty \left(1 - exp\left(-\frac{t}{\tau}\right)\right)$$

Wherein T(t) is the temperature at time *t*, $T_\infty$ is the ambient temperature, *t* is time, and $\tau$ is the characteristic time constant of the component, in this case of the electrical part 11. After fitting the data to the exponential function, a characteristic time constant $\tau$ is identified. In thermal systems, the characteristic time constant ($\tau$) may serve as a crucial parameter that may characterize the system's response to changes in temperature. For example, it may represent the time required for the temperature of the system to reach approximately 63.2% of its final equilibrium value in response to a step change in input or external conditions. This time constant may indicate how fast the electrical system 10 or its components responds to temperature changes. A smaller value of $\tau$ may indicate that the electrical part 11 responds quickly to changes, typically associated with short-term dynamic processes, while a larger value of $\tau$ may indicate slower dynamic processes associated with longer time scales. After fitting the data to the exponential function, key points in the curve can be determined, such as the ambient temperature $T_\infty$, an initial temperature *T(0),* and other relevant points important for analysis. Exponential functions may be used to model dynamic processes, such as temperature changes over time in this example, due to their ability to capture both rapid and gradual variations. In this example, utilizing an exponential function may allows for the characterization of the electrical system's 10 thermal behavior for example, particularly during a period of a temperature increase over time like start-up phases.

In this example, as mentioned before, it can be assumed that the measured temperature increase over time $T_1 + T_2$ is composed of two components or exponential functions, namely $T_1$ and $T_2$ and thus can be formulated as follows:

$$T(t) = T_{\infty,1} \left(1 - exp\left(-\frac{t}{\tau_1}\right)\right) + T_{\infty,2} \left(1 - exp\left(-\frac{t}{\tau_2}\right)\right)$$

The exponential functions consist of both two amplitudes and two time constants $\tau$. Because of $\tau$ can be linked to a different time scale of each of the components, for example shorter time scale for self-heating $\tau_1$ of the electrical part 11 or large time scale $\tau_2$ for heating due to heating contribution of a surrounding portion 16 of the electrical system 10, it may be possible to fit the two-exponential model and determine an amplitude or temperature increase over time of each component. This may allow to determine the self-heating of the electrical part 11 by using only one measurement device 12.

To summarize, to determine the heating contributions of the electrical part 11 and its surrounding portion 16, the measured temperature profile $T_1 + T_2$ may be analyzed. By identifying the amplitude of each exponential temperature increase ($T_1$ and $T_2$) corresponding to the characteristic temperature profiles of the electrical part 11, the heat due to self-heating and the surrounding portion 16 may be distinguished. This analysis may be conducted during periods of exponential temperature increase in the electrical system 10, such as during start-up or steady-state conditions after long heating up period for example for example. These insights enable accurate assessment of thermal behavior and facilitate effective temperature management strategies for the electrical system.

Figure 3 schematically and exemplary illustrates a method 100 solving the aforementioned. Namely, the method 100 may be for determining a health status of an electrical part 11 of the electrical system 10 of Fig. 1.

In a first step 101 measurement data is obtained, based on a measured temperature profile at a position of the electrical part 11 of the electrical system 10. This temperature profile may be derived from at least two temperature profiles over time: a first temperature of the electrical part 11, related to self-heating due to resistive loss, and at least a second temperature over time related to heating due to resistive loss of a surrounding portion 16 of the electrical system 10. In a second step 102 characteristic data of the electrical part 11 is obtained. This data may include at least one characteristic temperature profile of the electrical part 11 over time, relating to its self-heating and the heating of the surrounding portion 16. These characteristic data may be derived from experimental measurements or simulations and may serve as a reference for comparison with the measurement data. In a next step 103, based on the measurement data and the characteristic data, a first temperature, or self-heating, of the electrical part 11 over time is determined. This may involve fitting the measurement data to the characteristic data, such as applying a mathematical model describing the temperature increase of the electrical part 11. In an optional step 104, by using the determined first temperature of the electrical part 11 over time and a threshold temperature for example indicative of a fault operation, a health state of the electrical part 11 may determined. If the measured temperature may exceed the threshold, a fault condition may be detected, and appropriate actions may be taken.

While the invention has been illustrated and described in detail in the drawings and foregoing description, such illustration and description are to be considered illustrative or exemplary and not restrictive. The invention is not limited to the disclosed embodiments. Other variations to the disclosed embodiments can be understood and effected by those skilled in the art and practicing the claimed invention, from a study of the drawings, the disclosure, and the claims.

As used herein, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Further, as used herein, the phrase "at least one" or similar, e.g., "one or more of", in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that such entities may optionally be present other than the entities specifically identified within the list of entities to which the phrase "at least one" or similar refers, whether related or unrelated to those entities specifically identified. Thus, as a non-limiting example, "at least one of A and B" (or, equivalently, "at least one of A or B" or, equivalently "at least one of A and/or B" or, equivalently "one or more of A and B", "one or more of A or B", or "one or more of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

As used herein, the phrase "being indicative of" may for example mean "reflecting" and/or "comprising". Accordingly, an entity, element and/or step referred to herein as "being indicative of [...]" can be synonymously or interchangeably used herein with one, two or all of said entity, element and/or step "comprising [...]" and said entity, element and/or step "reflecting [...]". Further, as used herein, phrases such as "based on", "related" or "relating", "associated" and similar are not to be seen exclusively in terms of the entities, elements and/or steps to which they are referring, unless otherwise stated. Instead, these phrases are to be understood inclusively, unless otherwise stated, in that, for example, an entity, element or step referring by any of these phrases or similar, e.g., being "based on", an or another entity, element or step, does not exclude that the respective entity, element or step may be further or also "based on" any other entity, element or step than the one to which it refers.

The designation of methods and steps as first, second, etc. as provided herein is merely intended to make the methods and their steps referenceable and distinguishable from one another. By no means does the designation of methods and steps constitute a limitation of the scope of this disclosure. For example, when this disclosure describes a third step of a method, a first or second step of the method do not need to be present yet alone be performed before the third step unless they are explicitly referred to as being required per se or before the third step. Moreover, the presentation of methods or steps in a certain order is merely intended to facilitate one example of this disclosure and by no means constitutes a limitation of the scope of this disclosure. Generally, unless no explicitly required order is being mentioned, the methods and steps may be carried out in any feasible order. Specifically, the terms first, second, third or (a), (b), (c) and the like in the description and in the claims are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

In the context of the present invention any numerical value indicated is typically associated with an interval of accuracy that the person skilled in the art will understand to still ensure the technical effect of the feature in question. As used herein, the deviation from the indicated numerical value is in the range of $\pm$ 10%, and preferably of $\pm$ 5%. The aforementioned deviation from the indicated numerical interval of $\pm$ 10%, and preferably of $\pm$ 5% is also indicated by the terms "about" and "approximately" used herein with respect to a numerical value.

Any reference signs in the claims should not be construed as limiting the scope.

**Claims**

1. A method for an electrical system (10), the method comprising:

    - obtaining measurement data indicative of a measured temperature profile at a position of an electrical part (11) of the electrical system (10), wherein the measured temperature profile is based at least on:

        ∘ a first temperature of the electrical part (11) over time relating to a self-heating due to resistive loss of the electrical part (11), and
        ∘ at least a second temperature over time relating to a heating due to resistive loss of a surrounding portion (16) of the electrical system (10), the surrounding portion (16) at least partially surrounding the electrical part (11);

    - obtaining characteristic data of the electrical part (11), the characteristic data comprising at least one characteristic temperature profile of a temperature of the electrical part (11) over time due to the self-heating of the electrical part (11) or of a temperature of the electrical part (11) over time due to the heating of the surrounding portion (16); and
    - determining the first temperature of the electrical part (11) over time based on the measurement data and the characteristic data.

2. The method of claim 1, wherein the first temperature of the electrical part (11) over time is determined based on a fitting of the measurement data with the characteristic data.

3. The method of claim 1 or 2, wherein the at least one characteristic temperature profile comprises:

    - a first characteristic temperature profile of a temperature of the electrical part (11) over time due to the self-heating of the electrical part (11), and
    - a second characteristic temperature profile of a temperature of the electrical part (11) over time due to the heating of the surrounding portion (16).

4. The method of claim 3, wherein the first characteristic temperature profile of a temperature of the electrical part (11) and the second characteristic temperature profile of a temperature of the electrical part (11) is obtained under a fault-free operation of the electrical system (10), the method further comprising:

    - determining a state of health of the electrical part (11) based on the first temperature of the electrical part (11) over time and a threshold temperature of the electrical part (11) over time indicative of a fault operation of the electrical part (11).

5. The method of any one of the previous claims, wherein a thermal mass of the electrical part (11) is smaller than a thermal mass of the surrounding portion (16).

6. The method of any one of the previous claims, wherein the characteristic data is predetermined based on

    ∘ at least one simulation of the electrical system (10), and/or
    ∘ at least one usage condition with the electrical system (10).

7. The method of any one of the previous claims, wherein the measurement data indicative of a measured temperature profile is obtained during a period of a temperature increase over time.

8. The method of claim 6, wherein the period of the temperature increase over time is during a substantially exponential temperature increase.

9. The method of claim 6 or 7, wherein the period of the temperature increase over time is during a start-up phase of the electrical system (10) or between steady-state temperatures of the electrical part (11).

10. The method of any one of the previous claims, wherein the electrical part (11) is an electrical contact, an electrical portion or an electrical component of the electrical system (10).

11. The method of any one of the previous claims, wherein the measured temperature profile is based on a temperature measured by a temperature sensor of the electrical system (10), in particular the electrical part (11).

12. A data processing system (13) configured for carrying out the method of any one of the previous claims.

13. An electrical system (10) comprising an electrical part (11), a measurement arrangement configured to measure a temperature of the electrical part (11), and the data processing system (13) of claim 12.

14. A computer program product (15) comprising instructions which, when the program is executed by a computer, cause the computer to carry out the method of any one of claims 1 to 11.

15. A computer-readable storage medium comprising instructions which, when executed by a computer, cause the computer to carry out the method of any one of claims 1 to 11.

Fig. 1

Fig. 2

100

101

102

103

104

Fig. 3

Europäisches
Patentamt

European
Patent Office

Office européen
des brevets

## EUROPEAN SEARCH REPORT

**Application Number**

EP 24 16 5992

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/393634 A1 (TANAKA MASAHITO [JP] ET AL) 8 December 2022 (2022-12-08) | 1,3-15 | INV.<br>G01K1/20<br>G01K7/42<br>H02H6/00 |
| A | * paragraphs [0001], [0010], [0011] - [0024], [0035], [0037] - [0043], [0046] - [0048], [0050] - [0052], [0056], [0059]; figure 3 * | 2 | |
| A | US 2022/337037 A1 (OSTROWSKI JOERG [CH] ET AL) 20 October 2022 (2022-10-20)<br>* paragraphs [0005] - [0011], [0015] - [0022], [0042] * | 1-15 | |

**TECHNICAL FIELDS SEARCHED     (IPC)**

G01K

The present search report has been drawn up for all claims

| Place of search | Date of completion of the search | Examiner |
|---|---|---|
| The Hague | 5 September 2024 | Phleps, Stefanie |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 16 5992

This annex lists the patent family members relating to the patent documents cited in the above-mentioned European search report.
The members are as contained in the European Patent Office EDP file on
The European Patent Office is in no way liable for these particulars which are merely given for the purpose of information.

05-09-2024

| Patent document cited in search report | Publication date | Patent family member(s) | Publication date |
|---|---|---|---|
| US 2022393634 A1 | 08-12-2022 | CN 114585890 A | 03-06-2022 |
| | | DE 112020005865 T5 | 15-09-2022 |
| | | JP 7388158 B2 | 29-11-2023 |
| | | JP 2021087325 A | 03-06-2021 |
| | | US 2022393634 A1 | 08-12-2022 |
| | | WO 2021106430 A1 | 03-06-2021 |
| US 2022337037 A1 | 20-10-2022 | CN 115267609 A | 01-11-2022 |
| | | EP 4075112 A1 | 19-10-2022 |
| | | US 2022337037 A1 | 20-10-2022 |

EPO FORM P0459

For more details about this annex : see Official Journal of the European Patent Office, No. 12/82